# EUROPEAN PATENT APPLICATION

(11) **EP 4 618 732 A1**
(43) Date of publication of application: **17.09.2025**
(21) Application number: 25160442.7
(22) Date of filing: 27.02.2025
(51) Int. Cl.: H10N 60/20, H10N 60/01, H01F 6/06

(54) **DEVICE COMPRISING MULTIPLE LAYERS OF HIGH-TEMPERATURE SUPERCONDUCTING (HTS) TAPES COMPRISING GRAPHITE SHEETS, AND METHOD FOR FABRICATING THE DEVICE**

(30) Priority: 01.03.2024 IT 202400004555
(71) Applicant: Istituto Nazionale di Fisica Nucleare, 00044 Frascati (RM) (IT)
(72) Inventor: BIANCHI, Antonio, FRASCATI (IT)
(74) Representative: Metroconsult Srl

(57) **Abstract**

Device formed of multiple layers of HTS superconductor material tapes (61, 71), comprising graphite sheets (62, 72) interposed between said multiple layers of superconductor material tapes.

## Description

### Field of the invention

The present invention relates to a device formed of multiple layers of high-temperature superconductor (HTS) material tapes comprising graphite sheets interposed between the layers of said tapes, and also to a method of fabricating such device.

### Technical problem to be solved

While the wires of magnets built with low-temperature superconductors are usually insulated and wound into coils, insulating high-temperature superconductor tapes is impracticable for most high-field magnets because of the high current and high energy stored in the coils.

According to recent literature, high-temperature superconductors (HTS) typically have a critical temperature which is higher than that of liquid nitrogen at atmospheric pressure (77 K), whereas low-temperature superconductors (LTS) have a critical temperature which is lower than 77 K.

Superconductor magnets consist of coils (HTS tape wound on itself) through which electric current is made to flow. Due to this current flow, a magnetic flow is induced. Therefore, an assembly consisting of multiple coils is simply referred to as a magnet.

High-field magnets are those with a magnetic field in excess of 15 T, and at present can only be fabricated through the use of HTS superconductors.

One of the most critical aspects of superconductor magnets is the need to immediately detect any quench events in order to protect the magnets against the irreversible damage that could result. Quenching is a phenomenon that occurs when local perturbation, e.g. mechanical vibration, within a superconductive coil causes a significant increase in the temperature of the superconductor wire or tape. The increased temperature results in the material undergoing a transition from a superconductive state to a resistive state, with a sudden increase in local electric resistance. The current flowing in the resistive conductor causes the generation of heat through the Joule effect. As a consequence, the generated heat increases the temperature of other parts of the magnetic coil, causing them to undergo a complete transition from the superconductive state to the resistive state. The temperature increase in the coil may be so great and fast as to cause irreversible damage to the entire superconductor magnet.

The introduction of non-insulated windings has represented a significant step forwards in the development of HTS superconductor magnet technology. Indeed, non-insulated coils for high-field HTS magnets offer several advantages over conventional insulated coils. Due to the low contact electric resistance between the windings, when quenching occurs in a non-insulated HTS coil the current automatically bypasses the resistive zone, thus avoiding the formation of a hot point and providing self-protection against quench events. In extreme cases, it will be sufficient to use a quench detection and protection system, which can be implemented with currently available technology, to avoid irreversible damage to the magnet. Non-insulated coils also offer better structural stability when cooled to cryogenic temperatures, due to the absence of any insulating material, which generally has thermal contraction and expansion coefficients which are different from those of HTS tapes.

At present, however, non-insulated coil technology still has some drawbacks. The absence of insulation between the windings results in the presence of distributed currents in the coil that cause magnetic field variations, making this technology unfit for many applications, such as particle accelerators, which require extraordinary magnetic field uniformity. Moreover, the absence of insulating material between the windings of HTS coils extends the magnet charging time considerably, up to levels that are unacceptable for most applications. Lastly, non-insulated coils typically suffer from excessive heat losses when the rated current is reached quickly: this is a very important limitation, especially for magnets where the magnetic field needs to be varied in a very short time and cooling power is limited.

### Description of the prior art

Superconductors are materials having unique properties at low temperatures, such as total absence of electric resistance and magnetic field expulsion.

Superconductor materials are typically divided into low-temperature superconductors (LTS) and high-temperature superconductors (HTS).

LTS materials, like niobium (Nb), niobium-titanium (NbTi) or niobium-3-tin (Nb₃Sn), are metals or metal alloys having a critical temperature which is lower than that of liquid nitrogen (77 K), and whose superconductive behaviour can be described by the known Bardeen, Cooper and Schrieffer (BCS) theory.

Conversely, the behaviour of HTS materials is not thoroughly described by the BCS theory, and such materials generally have critical temperatures in excess of 77 K. The most common HTS superconductors are cuprate superconductors, i.e. compounds containing a copper oxide group, such as BSCCO or ReBCO (where Re is a rare-earth element, typically Y or Gd). Other HTS materials include iron pnictides (e.g. FeAs and FeSe) and magnesium diboride (MgB₂).

Differently from LTS materials, HTS superconductors also have, in addition to a relatively high critical temperature, critical magnetic field values and critical current density values that are much higher than those of LTS superconductors. This makes HTS materials the ideal candidates for a wide range of large-scale applications, in addition to considerably reducing the complexity and cost of the cooling system. Their main applications include high-power electric energy transmission lines, high-efficiency generators and motors for electric energy production (e.g. wind turbines), and magnetic resonance imaging (MRI) equipment. Such materials provide stronger magnetic fields useful for ultrahigh-resolution analysis of human tissues as well as for scientific and research applications requiring the use of high-field magnets, e.g. particle physics and nuclear fusion.

The HTS material class which is most suitable for the fabrication of high-field magnets is the class of cuprates, particularly ReBCO. For example, yttrium barium cuprate (YBCO) has a critical temperature of 95 K, a critical magnetic field higher than 100 T, and a critical current density ranging between 10³ and 10⁴ A/mm². The high critical magnetic field value and the high critical current density value make ReBCO materials the ideal candidates for the fabrication of magnets with magnetic fields in excess of approx. 15 T. Furthermore, their high critical temperature allows these materials to be effectively cooled by liquid nitrogen, which is less expensive than the liquid helium currently in use, or by means of one of a wide range of commercially available cryocoolers.

Although no complete theory has been formulated yet to describe the superconductive behaviour of HTS materials, it is believed that the superconductive properties of such materials are affected by the electrons moving within the copper oxide layers that are present in their crystalline structure. Because of this, fabricating very long ReBCO superconductor wires is particularly difficult.

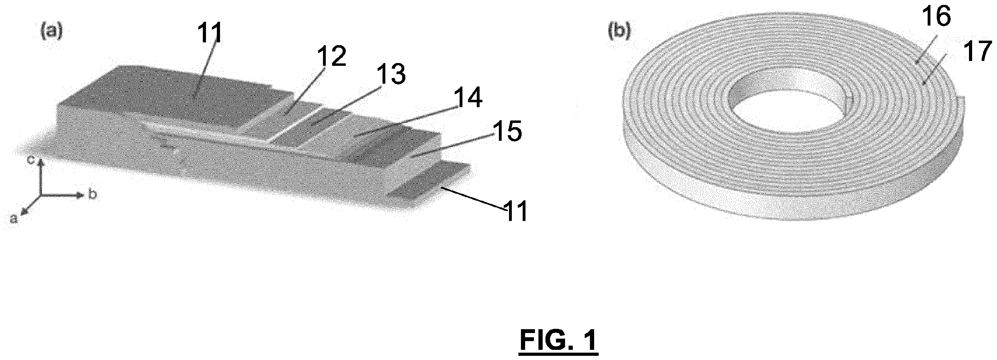

At present, most ReBCO superconductor wires available on the market are supplied in the form of tapes having a width of a few millimeters (usually 4 or 12 mm), a thickness of approx. 100-150 micrometers, and a length which may vary from a few hundreds of meters to one kilometer. To provide mechanical strength, such tapes consist mainly of a metal alloy. On the tapes, several layers of buffer materials are deposited, on which there is a layer, just a few micrometers thick, of HTS superconductor **(****Figure 1a****)** [Article: Barth, C. et al, Superconductor Science and Technology 28.4 (2015): 045011]. Both sides of the tape are coated with some tens of micrometers of copper to ensure high conductivity and thermal stability in operation. The biggest ReBCO tape manufacturers are based in the United States of America, China, South Korea and Japan. In Europe there are only a couple of Germany-based factories. In the following, ReBCO tapes will be called HTS tapes to refer in general to any commercially available tape consisting of a high-temperature superconductor.

The use of HTS materials for high-field magnets is currently the subject of intensive research. As far as Europe is concerned, the European Strategy for Particle Physics 2020 highlights the need for expanding the research and development of high-field superconductor magnets. Geneva CERN has started the High-Field Magnets research and development program in co-operation with the national laboratories of member states and associate member states. The goals of this program include investigating HTS magnetic technologies for particle accelerator applications and developing the next generation of high-field magnets for accelerators.

While the wires or tapes of magnets fabricated with LTS superconductors are usually insulated and wound into coils **(****Figure 1b****),** insulating HTS tapes is impracticable for most high-field magnets because of the high current and high energy stored in the coils. Insulating HTS tapes for high-field magnets almost always implies the need for a quench detection system, which may turn out to be very costly for this type of magnets and also, most likely, ineffective in preserving it from irreversible damage. As a matter of fact, when local perturbation, e.g. mechanical vibration, occurs in the superconductive coil, the temperature of the superconductor may increase significantly due to the low specific heat of these materials at cryogenic temperatures. This results in the material undergoing a transition from superconductor to resistive conductor. Because of this transition, the electric resistance of the conductor increases locally by several orders of magnitude, generating heat through the Joule effect as current flows therethrough. The produced heat will then cause other parts of the superconductor material to undergo the same transition, finally leading to the entire coil suffering a quench event. With a view to mitigating quench effects on magnet coils, HTS tapes are normally externally coated with copper to improve their overall electric and thermal conductivity. However, this solution is often insufficient for most high-field magnets because of the high current and high magnetic energy stored therein, which are transformed into huge amounts of heat when a quench event occurs. In point of fact, if a quench event is not detected immediately and the excess heat is not dissipated effectively, the entire coil may reach extremely high temperatures, causing irreversible damage to the whole magnet.

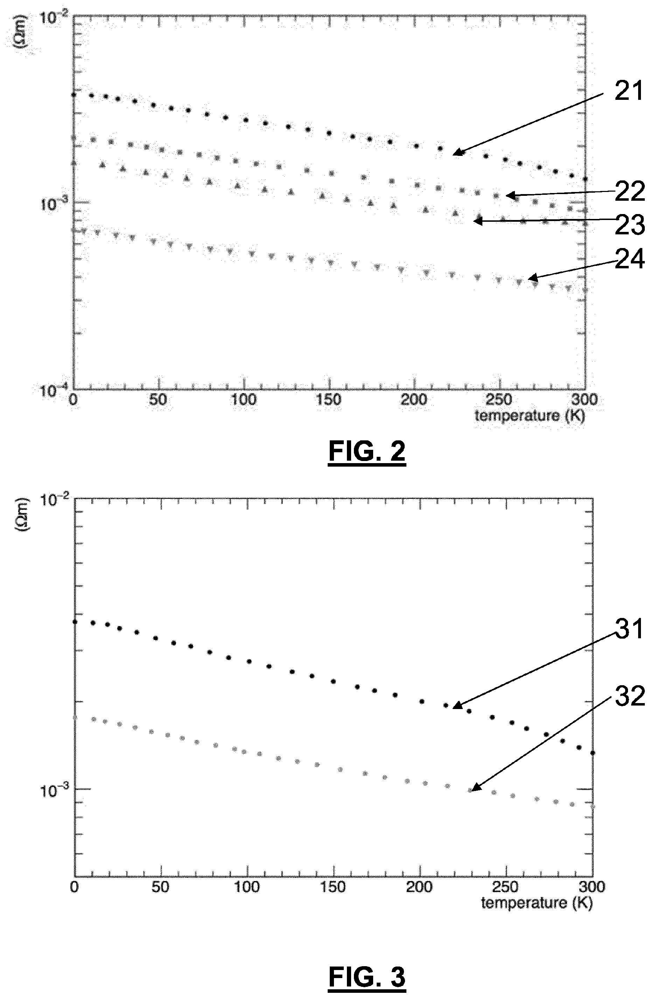

In more detail, **Figure 1a** shows an example of a known HTS tape approximately 100µm thick, externally coated with copper 11 by electrochemical deposition. The deposited copper has a variable thickness of about ten micrometers, and the residual resistance ratio (RRR) is usually in the range of 30 to 50. Further layers are silver 12, ReBCO HTS 13, some buffer layers 14, whereon the superconductor film can be grown, and metal alloys 15, which normally constitute the substrate. **Figure 2b** shows a portion of a circular magnet coil of a type known in the art. The coil consists of HTS tape (ReBCO tape) 16 wound on itself, with the optional addition of a known filler material (interlayer) 17 between the windings.

The introduction of non-insulated windings has represented a significant step forwards in the development of HTS superconductor magnet technology. Due to the low contact electric resistance between the windings, when a quench event occurs in a non-insulated HTS coil the current automatically bypasses the resistive zone, avoiding the formation of a hot point and providing self-protection against quench events. In extreme cases, it will be sufficient to use a quench detection and protection system, feasible with currently available technology, to prevent the magnet from suffering permanent damage. Thus, a non-insulated HTS coil turns out to be extremely stable, while also permitting a reduction in the amount of copper in the HTS tape. This leads to a significant increase in the mechanical strength of HTS tapes and their engineered critical current density, i.e. the maximum current that the superconductor can conduct divided by the total cross-section of the tape. This makes it possible to fabricate very compact magnets with a high magnetic field. Moreover, non-insulated coils feature greater structural stability when cooled to cryogenic temperatures, thanks to the absence of any insulating material, which typically has thermal contraction and expansion coefficients that are different from those of HTS tapes. By winding non-insulated HTS tapes, it was possible to create the most powerful superconductor magnet of the world, capable of generating a record-breaking magnetic field intensity of 45.5 T [Article: Hahn, S. et al., Nature 570.7762 (2019): 496-499].

However, the absence of a full insulation between the windings results in the presence of distributed currents in the coils that cause variations in the magnetic field of the magnet, making this technology unfit for many applications, such as particle accelerators, which require magnets having extraordinary magnetic field uniformity. Moreover, the absence of any insulating material between the turns of the coils extends the magnet charging time considerably, up to levels that are unacceptable for most applications. Lastly, non-insulated coils typically suffer from excessive heat losses when the rated current is reached in a short time: this is a very important limitation, especially for magnets where the magnetic field needs to be varied quickly, and cooling power is limited.

Some recent literature works have evaluated the adoption of a filler material with optimal contact resistance between the coil windings, for the purpose of combining the advantages of non-insulated coil technology with those of insulated coil technology. The idea is to optimize the contact resistance between the windings of HTS tapes by inserting a filler material, so as to obtain a relatively short coil charging time and low heat losses during the charge, without jeopardizing the coil's ability to provide self-protection against quench events.

Some experimental works have studied the use of metals to be interposed between the windings, such as, for example, the use of a few tens of micrometers of steel, metal alloys or thin metal films between the HTS tapes [Article: Lécrevisse, T. et al., Superconductor Science and Technology 35.7 (2022): 074004]. Other literature solutions are based on the use of materials having temperature-dependent electric resistance; for example, some papers have tackled the use of different oxides deposited on HTS tapes, whose electric resistivity decreases as temperature increases [Article: Kirby, G. et al., IEEE Transactions on Applied Superconductivity 32.6 (2022), and Article: Vaskuri, A. et al., IEEE Transactions on Applied Superconductivity 33.5 (2023)]. Some alternative options include the use of paraffins or polymeric materials to impregnate the windings of the coil's HTS tapes. Since most of such filler materials are not good electric conductors, these solutions may also envisage the inclusion, in the filler material, of powders of materials having excellent electric properties. This may be done in order to reduce the contact resistance to a desired value. Most experimental works in the literature are still focused on determining the contact resistance on small samples, so that it is difficult to predict the actual electric and thermal behaviour of a coil in a high-field magnet.

Although it is difficult to determine an ideal contact resistance value for each application, most theoretical analyses, available in the literature, concerning quench propagation in HTS coils converge towards an ideal contact resistance value of about 10⁻⁷ Ωm². For example, the present Applicant has used a contact resistance value of approx. 10⁻⁷ Ωm² to design the 10T ESMA dipole [Article: Rossi, L. et al., IEEE Transactions on Applied Superconductivity 34.5 (2024): 4602406]. Similarly, a study for a magnet of approx. 30 T indicates the ideal contact resistance value as ranging between 10⁻⁸ Ωm² and 10⁻⁶ Ωm² [Article: Markiewicz, W. D. et al., Superconductor Science and Technology 29.2 (2015): 025001]. Within such range, quench propagation remains uniformly fast, and heat dissipation during the quench event remains adequately effective. On the contrary, with higher contact resistance values, quench propagation slows down and the coil begins to overheat excessively, thus impairing its own integrity, while a lower contact resistance value implies an excessively long magnet charge time, as was the case with a prototype of the 26T MIT-FBML magnet, which reached the rated field in more than 15 hours on account of a contact resistance value of approx. 9.6×10⁻¹⁰ Ωm² [Article: Yoon, S. et al., Superconductor Science and Technology 29.4 (2016): 04LT04]. For these reasons, a contact resistance range of 10⁻⁸ to 10⁻⁶ Ωm² has been commonly adopted for designing most high-field magnets.

### Summary of the invention

The object of the present invention is to provide a device consisting of multiple layers of high-temperature superconductor (HTS) material tapes comprising graphite sheets interposed between the tape layers in order to solve the above-mentioned problems.

The solution provided by the present invention envisages the use of graphite, which is a material having anisotropic electric and thermal properties, in order to optimize the charging time of high-field magnets and mitigate the effects of quench events. The use of this material will make it possible to adjust and optimize the contact resistance between HTS tape windings specifically for each application, while at the same time ensuring optimal electric and thermal conductivity in the windings' longitudinal direction, with values that may even, in some cases, be higher than those of copper.

The preferred solution adopted in the present invention comprises one or more graphite sheets of variable thickness (from a few micrometers to several hundreds of micrometers), preferably to be interposed between the HTS tape windings and/or to be directly deposited onto one or both of the surfaces of the HTS tapes prior to winding them into coils. This technology offers the possibility to improve the overall thermal conductivity of the HTS tapes, in addition to allowing the achievement of the desired value of longitudinal and transversal electric resistivity between windings of the same tape. Moreover, this technology makes it possible to obtain an optimal ratio between copper and graphite to improve the thermal and mechanical stability of the HTS tape and the general thermal and mechanical stability of coils for high-field magnets.

In further non-limiting examples, graphite sheets find application for fabrication of metal tapes, said graphite sheets being interposed between the HTS tape layers, with or without adhesive material. As aforementioned, the use of graphite sheets in this context makes it possible to accurately adjust the desired electric and thermal properties, thus contributing to optimizing the performance of high-field superconductor magnets, which require high thermal conductivity and accurate control of the electric resistance under cryogenic conditions.

The possible applications of the present invention are not limited to high-field magnets for accelerators, since they also extend to any device requiring the use of layers of high-temperature superconductor material tapes to transmit electric current and/or to reach intense magnetic fields.

It is one object of the present invention to provide a device formed of multiple layers of HTS superconductor material tapes, comprising graphite sheets interposed between said multiple layers of superconductor material tapes, as set out in claim 1.

It is another object of the present invention to provide a method of fabricating said device, as set out in claim 9.

A further object of the present invention concerns the use of graphite in a device according to claim 1.

Dependent claims 2 to 8 define some preferred variations of said device, while dependent claims 9 to 12 define some preferred variations of said method.

All claims are intended as integral parts of the present description.

### Brief description of the drawings

Further objects and advantages of the present invention will become apparent in light of the following detailed description of some exemplary embodiments thereof provided with reference to the annexed non-limiting explanatory drawings, wherein:
- Figure 1a shows an example of a known HTS tape, externally coated with copper by electrochemical deposition;
- Figure 1b shows an example of a known magnet coil consisting of HTS tape wound on itself, with the optional use of a filler material (interlayer) between the windings;
- Figures 2, 3, 4 and 5 show the evolution, as a function of temperature, of the values of some physical properties of the graphite sheets used in the present invention;
- Figures 6a, 6b, 7a, 7b, 7c and 7d show some examples of HTS tapes with graphite interlayers in accordance with the invention.

### Detailed description of some embodiments

In accordance with the present invention, the preferred solution for optimizing the charging time of high-field magnets and for reducing the effects of quench events employs graphite, as a filler material with anisotropic electric and thermal properties, between the windings of HTS coils. This technology offers the possibility to improve the overall thermal conductivity of HTS tapes, possibly while also reducing the amount of copper in a single tape, and also to achieve the desired value of longitudinal and transversal electric resistivity between the windings of a single tape. More specifically, the invention proposes the use of graphite sheets of variable thickness ranging from approx. 1 micrometer to approx. 1 millimeter, preferably from 10 micrometers to 500 micrometers, to be interposed between the windings of HTS tape and/or to be directly deposited onto one or both of the surfaces of the HTS tape prior to winding it into coils for high-field magnets.

Graphite is a form of crystalline carbon with a structure composed of layers of carbon atoms arranged in a regular pattern. The carbon atoms are typically disposed on the planes in a mesh-like hexagonal structure. Such planes are stacked over each other, with weak bonds between them. The carbon planes may be arranged in a more or less orderly configuration, giving graphite specific properties that depend on such configuration.

In one preferred arrangement according to the invention, the graphite sheets are disposed in such a way that the carbon planes are prevalently parallel to the plane whereon current flows in HTS tapes. Along the HTS tapes, the current flows in a planar manner. The choice of positioning the graphite sheets in this particular arrangement between the windings is dictated by the material's anisotropic characteristic and by its specific application for high-field magnets, as will be explained hereinafter.

By "prevalently parallel" it is meant herein that, from a crystallographic viewpoint, it is impossible that all carbon planes are perfectly parallel; therefore, reference is made to a statistically prevalent orientation.

Based on the disposition and alignment of the carbon planes, the transversal and longitudinal properties of graphite undergo variations. As a consequence, the electric and thermal properties may vary considerably among different graphite types. By way of non-limiting example, the drawings illustrate the electric resistivity and thermal conductivity - from 0 to 300 K - of pyrolytic graphite sheets of variable thickness. **Figure 2** shows the electric resistivity, as a function of temperature, of pyrolytic graphite in the direction perpendicular to the carbon layers, measured on four different sheets having a thickness of 10 µm (21), 17 µm (22), 25 µm (23), and 100 µm (24). [These properties are per se known, see Article: Nakamura, S. et al. "Low temperature transport properties of pyrolytic graphite sheet", Cryogenics 86 (2017): 118-122]. Increasing the thickness of the pyrolytic graphite sheet, electric resistivity increases over the whole temperature interval from 0 K to 300 K. In all cases, electric resistivity decreases approximately by a factor of 2 as temperature increases from 0 K to 300 K. Beyond an optimal value of electric resistivity between two windings, the reduction of this quantity as temperature increases further limits quench propagation. When a quench event occurs, in fact, there is a local increase in temperature; as a consequence, the current can easily redistribute itself in the adjacent windings that are still superconductive, due to the lower electric resistivity of the filler material caused by the higher temperature. This limits the production of heat through the Joule effect in the coil portion with resistive behaviour. On all tested samples, the equivalent contact resistance was between 10⁻⁸ and 10⁻⁷ Ωm².

According to some variations of the invention, when higher contact resistance values need to be obtained, e.g. between 10⁻⁷ Ωm² and 10⁻⁶ Ωm², it is possible to either increase the thickness of the pyrolytic graphite sheets or coat the pyrolytic graphite sheets with a polymeric or metallic film in order to increase or decrease its total contact resistance.

According to a further variation of the method, the desired contact resistance can be obtained by using compressed pyrolytic graphite sheets. **Figure 3** shows the variation in electric resistivity in the direction perpendicular to the carbon layers as a function of temperature in a compressed pyrolytic graphite sheet (32) and in an uncompressed pyrolytic graphite sheet (31), both having a thickness of 10 µm [These properties are per se known, see Article: Nakamura, S. et al. "Low temperature transport properties of pyrolytic graphite sheet", Cryogenics 86 (2017): 118-122].

The thickness dimension of each one of said graphite sheets may, as aforesaid, range from one micrometer to one millimeter, preferably from 10 micrometers to 500 micrometers, and may be either variable or constant in the same device.

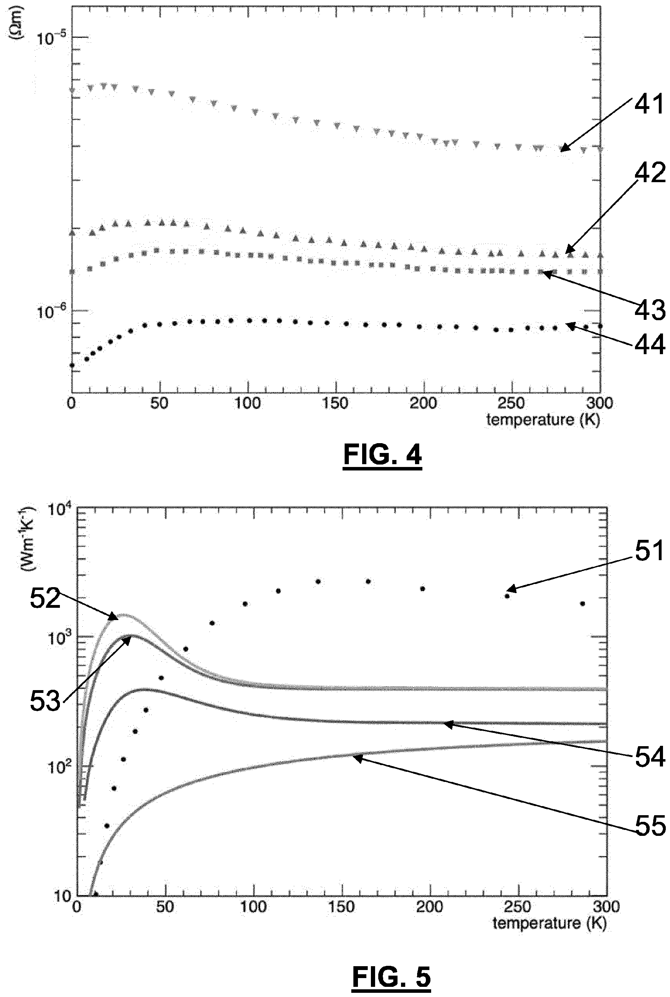

As already mentioned above, in order to obtain the desired value of contact resistance between the windings, the carbon planes of graphite must be prevalently parallel to the plane whereon current flows in HTS tapes, i.e. the surface of the graphite sheets should preferably be oriented parallel to the HTS tapes. Current flows in a planar manner along the HTS tapes. This particular arrangement offers an additional advantage, since pyrolytic graphite has excellent electric and thermal properties in the direction parallel to the carbon layers, thus allowing for optimal current and heat redistribution in case of a quench event. **Figure 4** shows the electric resistivity of pyrolytic graphite in the direction parallel to the carbon layers, as a function of temperature, for four sheets having a thickness of 10 µm (44), 17 µm (43), 25 µm (42), and 100 µm (41). [These properties are per se known, see Article Nakamura, S. et al. "Low temperature transport properties of pyrolytic graphite sheet", Cryogenics 86 (2017): 118-122]. The electric resistivity along the carbon layers does not change significantly between 0 K and 300 K, being generally constant for temperatures in excess of 100 K.

The electric resistivity of pyrolytic graphite in the direction parallel to the carbon layers is greater by two order of magnitude than that of copper at room temperature, thus effectively contributing to current redistribution in case of a quench event. In addition, the temperature increase that occurs during a quench event is mitigated by graphite due to its high thermal conductivity, which is even higher than that of copper and aluminium for temperatures in excess of 60 K. **Figure 5** shows, as a function of temperature, the thermal conductivity of pyrolytic graphite (curve 51) along the direction parallel to the carbon layers (c-axis) [These properties are per se known, see Article: Nakamura, S. et al. "Low temperature transport properties of pyrolytic graphite sheet", Cryogenics 86 (2017): 118-122], compared with that of copper (with, respectively, RRR equal to 30 (curve 53) and 50 (curve 52)) [These properties are per se known, see Article Simon, N. J. et al., "Properties of copper and copper alloys at cryogenic temperatures", (1992): doi:10.2172/5340308] and with that of aluminium (Al 1100 (curve 54) and Al 6061 (curve 55)) [These properties are per se known, see source *NIST Standard Reference Database],* both of which are materials known for their high thermal conductivity at cryogenic temperatures.

As shown in **Figure 5****,** the thermal conductivity of pyrolytic graphite is greater by one order of magnitude than that of the most common types of aluminium used for cryogenic applications, and about seven times higher than that of copper. Already at temperatures above 60 K, the thermal conductivity of pyrolytic graphite is higher than that of copper. This temperature value is much lower than the critical temperature of ReBCO superconductors, which ranges between approx. 90 K and 110 K. This implies that, along the direction parallel to the carbon layers, graphite acts as a thermal stabilizer, in a manner comparable with, or even better than, copper deposited externally on HTS tapes. Furthermore, it is apparent that the ratio between the amounts of copper and graphite represents an additional parameter that can be optimized to control the evolution of a quench event in HTS coils over time.

In summary, due to the anisotropic electric and thermal properties of graphite sheets, the latter can be used as interlayers placed between the windings of HTS tape, with or without adhesive material, and/or directly deposited on one or both surfaces of HTS tapes for the purpose of optimizing the charging time and mitigating the quench effects in high-field superconductor magnets, thereby combining the advantages of non-insulated winding technology with those of insulated winding technology.

It must be pointed out that the graphite sheets must not necessarily be made of pyrolytic graphite. The choice of the graphite type will depend on specific requirements and applications. Other graphite types, having per se known characteristics, which may be used for specific applications within the scope of the present invention include:
- graphite sheets available under the brand name *Grafoil*^{®}, obtained from small crystals of natural graphite (usually smaller than 10-20 nanometers), which are first pulverized, then exfoliated at high temperature, and finally laminated under high pressure;
- graphite sheets available under the brand name *ZYX*^{®}, synthesized starting from highly oriented pyrolytic graphite (HOPG), where the size of the graphite crystals is typically greater than 100-200 nanometers;
- pyrolytic graphite sheets (PGS) with a structure similar to a single crystal, synthesized by thermal decomposition of polymeric films;
- natural graphite sheets.

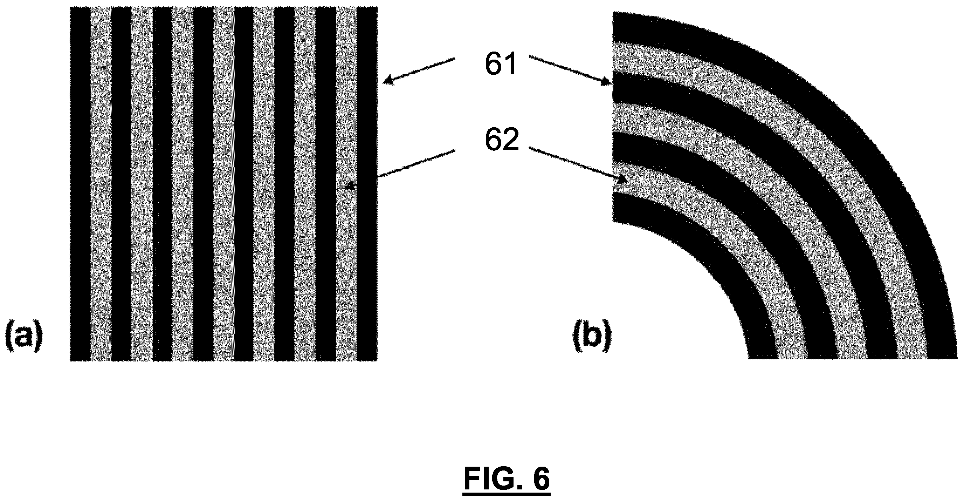

The following will describe some possible arrangements of the graphite sheets in coils for high-field magnets. This list of possible arrangements should be understood to be non-limiting. **Figure 6a** shows the cross-section of a portion of a coil for high-field magnets, while **Figure 6b** shows a plan view of a portion of a circular coil for high-field magnets. The drawings only show a limited portion of a generic coil, wherein the HTS tape is black and identified by numeral 61 in **Figures 6a** and **6b****.** The tape is wound on itself, with the interposition of a graphite sheet between two adjacent windings, which is represented in pale grey and identified by numeral 62. The drawings, included herein as examples, are not in scale and only show a small number of coil windings.

To form the coil, the graphite sheets must be arranged along the HTS tape, or glued onto the HTS tape, before the latter is wound on itself.

According to an alternative version, one or more graphite sheets are alternated with metallic or polymeric tapes of suitable size and thickness, to be wound together with the HTS tape in order to appropriately adjust the contact resistance between adjacent windings.

In such further variants, the thickness dimensions of the graphite sheets may be as defined above.

The thickness of the metallic or polymeric tapes may vary from 1 micrometer to 1 millimeter. As concerns the thickness of the metallic tapes, the preferable range is 10 micrometers to 500 micrometers, while for polymeric tapes the preferable range is 1 micrometer to 100 micrometers. Said thickness dimension may be either constant or variable in the device. The metallic or polymeric tapes may be in film form.

In all of the above-mentioned cases it is possible to position the filler material, consisting of one or more graphite sheets and one or more optional tapes of metallic or polymeric material, in contact with the HTS tape. After contact has been established, whether by simple superimposition of the filler material on the HTS tape or vice versa, or by gluing, they can be wound together around the coil core. This will ensure that, in the coil, the layers of HTS tape will alternate with the filler material as desired.

The filler material may be made to remain in position between two layers of HTS tape due to the mechanical tension exerted while winding the whole coil, or it may be fixed through the use of adhesive materials, conductive or insulating grease, or conductive or insulating paint, disposed along one or both of the contact interfaces between the HTS tape and the filler material.

Such materials, useful to provide adherence between the filler material and the surfaces of the HTS tape, can be added to the contact interfaces prior to winding the coil. For example, they may be disposed along the HTS tape and/or along the graphite sheets and then wound around the coil core while winding the HTS tape together with the filler material. As an alternative, they may be applied after the winding operation by impregnating the entire coil.

According to a further variant, the coil can be formed by producing HTS tapes with a coating consisting of one or more graphite sheets deposited on one or more external surfaces of the HTS tape. In this way, the HTS tape can be simply wound on itself to form the coil, which will thus consist of layers of HTS tapes alternated with graphite sheets. This solution also avoids the need for applying or gluing the graphite sheet on the HTS tape and then winding it around the coil core together with the HTS tape.

Yet another variant employs metallic tapes of suitable size and thickness (as to the preferred dimensional ranges, see above) externally coated with graphite sheets on one or both surfaces and then interposed between the layers of HTS tape of the coil.

Graphite can be deposited directly onto HTS tapes or onto suitable metallic tapes by using different deposition techniques, such as physical vapor deposition, particularly sputtering (diode sputtering, magnetron sputtering, or high-power impulse magnetron sputtering), cathodic arc, or evaporation. Also, deposition of graphite films on HTS tapes can be achieved through deposition techniques such as chemical vapor deposition and plasma enhanced chemical vapor deposition. Lastly, electrodeposition can be used for depositing graphite onto HTS tapes (e.g. onto the outer surface of the HTS tape) or, more generally, onto metallic tapes.

In all variants, the other dimensions of the graphite sheets, metallic sheets and polymeric sheets, i.e. their width and length, are similar to the dimensions of the HTS tapes. Their width will thus range between a few millimeters and a few centimeters, and their length will range between a few centimeters and a few kilometers.

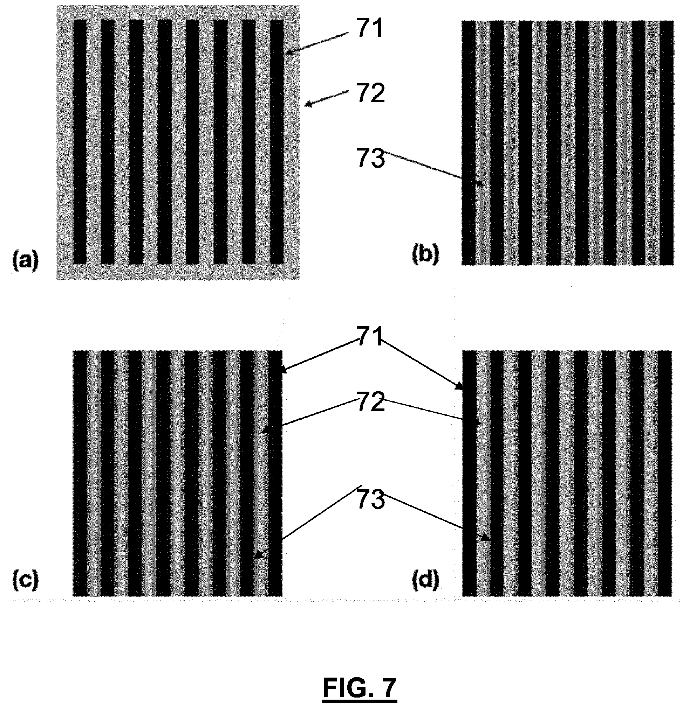

**Figure 7** shows further non-limiting examples of alternative arrangements of the graphite sheets within an HTS coil. The HTS tape is shown in black and identified by numeral 71, the graphite sheets are shown in pale grey and identified by numeral 72, and the layers of metallic or polymeric material, optionally having adhesive properties, are shown in dark grey and identified by numeral 73. These material layers, identified by numeral 73 in **Figure 7****,** can be added between the windings to adjust and optimize the contact resistance and thermal conductivity of the coil's filler material depending on the application.

The material layers identified by numeral 73 (i.e. the layers of metallic or polymeric material, optionally having adhesive properties) may be disposed on one **(****Fig. 7d****)** or both **(****Fig. 7c****)** sides of the graphite sheets. Alternatively, between two contiguous layers of HTS tape there may be two graphite sheets **(****Fig. 7b****),** between which a layer of material 73 can be inserted.

More specifically, the components shown in **Figure 7** in dark grey and identified by numeral 73 may also consist of conductive grease or insulating grease or conductive paint or insulating paint. **Figure 7a** shows the cross-section of a portion of a generic coil wherein the tape is surrounded on its sides, totally or partially, by further graphite sheets, in addition to those interposed between the tape layers. In **Figure 7b** the HTS tape is wound on itself with the interposition of a metallic tape externally coated with graphite sheets. The winding operation can be carried out with or without the presence of an adhesive material at the contact interfaces, depending on the application's requirements. **Figure 7c** shows the cross-section of a coil portion wherein the HTS tape alternates with a graphite sheet. Along the contact interfaces between the HTS tape and the graphite sheets there is a metallic or polymeric material, optionally having adhesive properties, or insulating or conductive grease, or insulating or conductive paint. Lastly, a variation of the configuration shown in **Figure 7c** is illustrated in **Figure 7d****,** wherein one side of the graphite sheet is directly in contact with the HTS tape, while the opposite side of the graphite sheet is placed in contact with the HTS tape through a metallic or polymeric material (or film), optionally having adhesive properties, or through insulating or conductive grease, or through insulating or conductive paint, depending on specific requirements and applications.

**In** **Figures 6** and **7****,** the dimensions of the HTS tape and of the filler material between the windings must not necessarily be identical.

In addition to protecting the coils from quenching and reducing their charging time, the use of graphite sheets also offers further advantages, which are briefly summarized below:
- Graphite sheets are extremely pliable and flexible, easy to handle, and non-toxic;
- Graphite sheets can be produced in various gauges: from a few micrometers to hundreds of micrometers;
- Graphite is a low-cost, easily available material;
- Graphite is used as a lubricant in cryogenics, and this makes it possible to minimize the problems caused by the thermal contraction and expansion that occur when the coil, which is composed of numerous materials having different properties, is cooling down or heating up. Moreover, no delamination of the HTS tapes can occur, which is often a problem with many glues and resins;
- Since graphite is soft and flakes easily, adhesion with HTS tapes is optimal and ensures better thermal and electric contact at the interface between the HTS tape and the filler material. Furthermore, graphite sheets can be used without necessarily requiring the use of grease, glue or resin that vitrify at low temperatures, thus preventing any problems that might result from the different thermal expansion of the coil's structures;
- Graphite is lighter than aluminium and weighs four times less than copper, thus allowing the fabrication of lighter magnets;
- Graphite is radiation-resistant and can therefore be used in high-field magnets for particle accelerators. Moreover, graphite is resistant to high temperatures, so that heat treatments can be applied during the coil manufacturing process.

The above-described example of embodiment may be subject to variations without departing from the protection scope of the present invention, including all equivalent designs known to a person skilled in the art.

The elements and features shown in the various preferred embodiments may be combined together without however departing from the protection scope of the present invention.

From the above description, those skilled in the art will be able to produce the object of the invention without introducing any further construction details.

## Claims

1. Device formed of multiple layers of HTS superconductor material tapes (61, 71), comprising graphite sheets (62, 72) interposed between said multiple layers of superconductor material tapes.

2. Device as in claim 1, wherein said graphite sheets (62, 72) are so arranged that the carbon planes of said graphite are prevalently parallel to the plane on which an electric current flows in said layers of HTS superconductor material tapes.

3. Device as in claim 1 or 2, wherein the thickness dimension of each one of said graphite sheets (62, 72) ranges from one micrometer to one millimeter, preferably from 10 micrometers to 500 micrometers, and is either variable or constant in said device.

4. Device as in any one of the preceding claims, wherein said graphite sheets (62, 72) are one or more of the following types:
- pyrolytic graphite sheets,
- compressed pyrolytic graphite sheets,
- graphite sheets obtained from natural graphite crystals pulverized, exfoliated at high temperature, and then laminated under high pressure;
- graphite sheets synthesized starting from highly oriented pyrolytic graphite;
- pyrolytic graphite sheets with a structure similar to a single crystal, synthesized by thermal decomposition of polymeric films;
- natural graphite sheets.

5. Device as in any one of the preceding claims, comprising further graphite sheets arranged in adherence to one or more outer sides of said device.

6. Device as in any one of the preceding claims, comprising layers of metallic or polymeric material, or conductive grease or insulating grease, or conductive paint or insulating paint (73) arranged along one or both of the contact interfaces between said layers of HTS tapes (61, 71) and said graphite sheets (62, 72), and/or on one or more outer sides of said device, and/or between two graphite sheets (62, 72) positioned between two contiguous layers of said HTS tape (61, 71).

7. Device as in claim 6, wherein the thickness dimensions of said metallic or polymeric tapes range from 1 micrometer to 1 millimeter, preferably said thickness of the metallic tapes ranging from 10 micrometers to 500 micrometers, and/or said thickness of the polymeric tapes ranging from 1 micrometer to 100 micrometers, said thickness dimensions being either variable or constant in said device.

8. Device as in claim 6 or 7, wherein said metallic or polymeric material is in film form.

9. Method of fabricating a device as in any one of claims 1 to 8, comprising the steps of:
- arranging and gluing said graphite sheets (62, 72) along said layers of HTS tape;
- winding said HTS tape (61, 71) on itself together with said graphite sheets around a coil core, thereby obtaining said device.

10. Method as in claim 9, comprising a further step of arranging further layers of metallic or polymeric material, or conductive grease or insulating grease, or conductive paint or insulating paint (73), along the contact interfaces between said layers of HTS tape and said graphite sheets, prior to said step of winding said HTS tape on itself.

11. Method as in any one of claims 9 to 10, wherein said arrangement of the graphite sheets and/or of the metallic or polymeric material (73) is obtained by means of one or more of the following deposition techniques:
- physical vapor deposition,
- sputtering, magnetron sputtering, high-power impulse magnetron sputtering,
- cathodic arc,
- evaporation,
- chemical vapor deposition,
- plasma enhanced chemical vapor deposition,
- electrodeposition.

12. Use of graphite in a device as in any one of claims 1 to 8, wherein said graphite is in the form of sheets (62, 72) interposed between said multiple layers of HTS superconductor material tapes (61, 71).
